(19) Europäisches Patentamt
European Patent Office
Office européen des brevets

(11) **EP 2 705 605 B1**

(12) **FASCICULE DE BREVET EUROPEEN**

(45) Date de publication et mention
de la délivrance du brevet:
**15.01.2020 Bulletin 2020/03**

(21) Numéro de dépôt: **12725100.7**

(22) Date de dépôt: **03.05.2012**

(51) Int Cl.:
*H03F 3/193* *(2006.01)*      *H03F 3/45* *(2006.01)*

(86) Numéro de dépôt international:
**PCT/FR2012/050992**

(87) Numéro de publication internationale:
**WO 2012/150420 (08.11.2012 Gazette 2012/45)**

(54) **CIRCUIT D'AMPLIFICATION ET CHAÎNE DE RÉCEPTION**

VERSTÄRKERSCHALTUNG UND EMPFANGSKETTE

AMPLIFICATION CIRCUIT AND RECEPTION CHAIN

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **05.05.2011 FR 1153859**

(43) Date de publication de la demande:
**12.03.2014 Bulletin 2014/11**

(73) Titulaire: **Commissariat à l'Énergie Atomique
et aux Énergies Alternatives
75015 Paris (FR)**

(72) Inventeurs:
• **BELMAS, François**
  **F-30650 Saze (FR)**
• **HAMEAU, Frédéric**
  **F-38250 Saint Nizier Du Moucherotte (FR)**

(74) Mandataire: **Bonnet, Michel
  Cabinet Bonnet
  93, rue Réaumur - Boîte 10
  75002 Paris (FR)**

(56) Documents cités:
**US-A1- 2007 057 724     US-A1- 2009 108 935
US-B2- 7 521 996**

**Description**

La présente invention concerne un circuit d'amplification et une chaîne de réception.

Dans le cadre de la présente invention, on appellera « circuit d'amplification » tout circuit présentant un signal de sortie correspondant au signal d'entrée multiplié par une valeur de multiplication pouvant prendre, en valeur absolue, n'importe quelle valeur positive, et en particulier n'importe quelle valeur comprise entre 0 et 1. Cette valeur de multiplication sera appelée « gain ». Les termes de « circuit d'amplification » et de « gain » seront ainsi utilisés même si, en toute rigueur, lorsque le gain est compris entre 0 et 1, le signal de sortie est atténué en amplitude par rapport au signal d'entrée.

Un circuit d'amplification à faible bruit, aussi désigné par l'acronyme LNA (de l'Anglais « Low Noise Amplifier »), a pour but d'amplifier un signal d'entrée en le dégradant le moins possible. Un exemple de LNA peut être trouvé dans le document de brevet US2007/0057724 A1.

Pour quantifier le bruit d'un LNA, il est connu d'utiliser une mesure de la dégradation de « l'écart entre un signal utile et un plancher de bruit ». Le signal de sortie du LNA contient trois composantes : le signal utile d'entrée amplifié par le gain du LNA, le bruit d'entrée amplifié par le gain du LNA et le bruit propre aux composants du LNA qui est directement injecté en sortie.

La façon dont le LNA injecte un bruit en sortie va donc avoir un impact sur l'écart entre le signal utile et le bruit avec les limites infranchissables suivantes : si la puissance du signal d'entrée est inférieure à la puissance du plancher de bruit alors le signal est « noyé » dans le bruit ambiant et le LNA ne pourra jamais faire ressortir le signal utile du bruit ambiant, et si le bruit propre injecté par le LNA en sortie est supérieur au signal utile amplifié, alors le LNA noie le signal avec son propre bruit.

Entre ces deux cas extrêmes, le LNA amplifie le signal d'entrée et le bruit d'entrée en réduisant légèrement l'écart entre ces deux grandeurs. Le LNA a donc un impact sur le rapport signal à bruit, qui est quantifié par un facteur de bruit F défini comme tel :

$$F = \frac{S/N_{entrée}}{S/N_{sortie}} > 1$$

$$NF = 10\log_{10}(F) > 0\,dB$$

où $S/N_{entrée}$ (respectivement $S/N_{sortie}$) est le rapport signal à bruit en entrée (respectivement en sortie). NF est la « figure de bruit », c'est-à-dire le facteur de bruit F sur une échelle logarithmique.

Puisqu'un LNA est toujours un minimum bruyant, $S/N_{sortie}$ est toujours plus petit que $S/N_{entrée}$, de sorte que F est strictement plus grand que 1 et NF strictement supérieur à 0 dB.

Un LNA est un amplificateur dont la figure de bruit NF est inférieure à 10 dB, de préférence inférieure à 7 dB, et de préférence encore comprise entre 1 et 3 dB de manière à correspondre aux valeurs usuelles des figures de bruit NF des LNA de l'état de la technique. Lorsque la figure de bruit NF est inférieure à 1 dB, la consommation électrique du LNA devient généralement très élevée (plus d'une dizaine de milliwatts).

Il est souvent nécessaire, en particulier dans les circuits radiofréquences, d'adapter les impédances entre les blocs afin d'éviter les réflexions parasites des signaux qui engendrent des pertes de puissance supplémentaires. La norme la plus répandue fixe l'impédance d'entrée des LNA à 50 Ω. Cette valeur est généralement considérée comme une basse impédance. Une des problématiques de conception des LNA consiste à s'assurer qu'ils présentent une impédance de 50 Ω avec une consommation électrique faible.

Pour adapter le LNA sur une basse impédance, minimiser son bruit propre, sa distorsion et pour maximiser son gain, il est connu d'utiliser des inductances passives. Plus précisément, trois inductances sont placées autour d'un transistor à effet de champ, chacune offrant un avantage particulier parmi ceux cités en début de paragraphe.

Le principal défaut de ces inductances concerne la surface nécessaire à leur réalisation. Il s'agit de composants qui occupent une surface plane très grande devant celle occupée par les transistors, qui sont de taille nanométrique.

Le coût d'un circuit est essentiellement lié à la technologie utilisée ainsi qu'à la surface du circuit. Les technologies modernes ayant un coût par mm$^2$ de plus en plus élevé, il devient nécessaire d'éviter autant que possible l'utilisation d'inductances passives.

Dans les années 1998-2000 une technique a été présentée concernant les LNA à entrées différentielles à base de transistor à effet de champ à grille commune. Cette technique, dite de couplage croisé capacitif, également désignée par l'acronyme CCCT (de l'Anglais « Capacitive Cross Coupling Technique »), propose schématiquement de piloter un transistor en agissant simultanément sur sa source et sur sa grille au moyen d'une seule capacité de couplage qui garantit que les tensions de source et de grille sont en opposition de phase. Cette technique permet d'augmenter la transconductance effective du transistor en montage à grille commune sans augmenter le courant continu utilisé pour créer cette transconductance. Cependant, du fait que le gain intrinsèque de la capacité de couplage ait une valeur absolue égale à 1, cette technique ne permet pas d'obtenir une transconductance effective qui soit supérieure à la transconductance naturelle du transistor multipliée par 2.

Des exemples de CCCT sont décrits dans les publications suivantes :

- S.B.T Wang, A.M. Niknejad, R.W. Brodersen, "Design of a Sub-mW 960-MHz UWB CMOS LNA," IEEE JSSC, vol. 41 no. 11. Nov. 2006,
- W. Zhuo, S. Embabi, J.P. De Gyvez, E. Sanchez-Sinencio, "Using Capacitive Cross-Coupling Technique in RF Low Noise Amplifiers and Down-Conversion Mixer Design," IEEE ESSCIRC, pp. 77-80, May 2000, et
- Woo, S. Kim, and al. "A 3.6mW Differential Common Gate CMOS LNA with Positive-Negative Feedback," IEEE ISSCC, pp. 218-219, Feb 2009.

Il existe également quelques documents proposant l'utilisation d'un amplificateur actif ou passif à la place de la capacité de couplage utilisée dans la technique CCCT. On peut citer en particulier :

- H. Wang, L. Zhang, Z. Yu, "A Wideband Inductorless LNA With Local Feedback and Noise Cancelling for Low-Power Low-Voltage Applications," IEEE TCAS I, vol. 57 no. 8, Aug. 2010,
- X .Li, S. Shekhar, D.J. Allstot, "Gm-boosted Common-Gate LNA and Differential Colpitts VCO/QVCO in 0.18-$\mu$m CMOS," IEEE JSSC, vol. 40 no.12 - Dec. 2005, et
- I.R. Chamas, S. Raman, "Analysis, Design, and X-Band Implementation of a Self-Biased Active Feedback gm-Boosted, Common-Gate CMOS LNA," IEEE MTT, vol. 57 no.3, Mar. 2009.

L'utilisation d'un amplificateur dont le gain est supérieur, en valeur absolue, à 1 permet d'augmenter la transconductance effective du transistor au-delà d'un facteur 2, contrairement à l'utilisation de la technique CCCT.

Cette augmentation de transconductance ayant pour effet d'augmenter l'admittance d'entrée du LNA (ce qui revient à diminuer l'impédance d'entrée de ce LNA).

L'invention a pour but de proposer un circuit amplification permettant encore d'améliorer le rapport admittance d'entrée sur consommation électrique d'un circuit d'amplification.

A cet effet, il est proposé un circuit d'amplification selon la revendication 1.

Dans le circuit proposé, l'admittance d'entrée est répartie entre au moins deux admittances : l'admittance principale et l'admittance secondaire, alors que dans l'état de la technique seule l'admittance principale contribue à l'admittance d'entrée du circuit d'amplification. Or, les inventeurs ont trouvé que cette répartition permettait d'obtenir un bon rapport admittance d'entrée sur consommation électrique. En effet, de manière générale, l'admittance ne varie pas linéairement en fonction de la consommation électrique du dispositif d'alimentation. En d'autres termes, l'augmentation de consommation électrique nécessaire à augmenter l'admittance est d'autant plus importante que cette admittance est élevée. Ainsi, il est plus avantageux de prévoir plusieurs petites admittances qui s'additionnent plutôt qu'une seule admittance élevée. Il est alors par exemple possible à consommation constante d'augmenter encore l'admittance d'entrée (et donc d'obtenir une impédance d'entrée encore plus faible). De façon similaire, il est par exemple possible à admittance d'entrée constante (c'est-à-dire à impédance d'entrée constante, par exemple de 50 $\Omega$) de diminuer encore la consommation électrique du circuit d'amplification.

Des caractéristiques optionnelles sont énoncées dans les revendications 2 à 9.

Il est également proposé une chaîne de réception selon la revendication 10.

L'invention sera mieux comprise à l'aide de la description qui va suivre, donnée uniquement à titre d'exemple et faite en se référant aux dessins annexés dans lesquels :

- la figure 1 est un schéma fonctionnel représentant une chaîne de réception radiofréquence,
- la figure 2 est un schéma électrique d'un circuit d'amplification de la figure 1, selon un premier mode de réalisation de l'invention,
- la figure 3 est un schéma électrique équivalent à celui de la figure 2, pour des signaux radiofréquences,
- la figure 4 est un schéma électrique d'une première variante de réalisation du circuit d'amplification de la figure 2,
- la figure 5 est un schéma électrique d'une seconde variante de réalisation du circuit d'amplification de la figure 2,
- la figure 6 est un schéma électrique d'un circuit d'amplification selon un deuxième mode de réalisation de l'invention,
- la figure 7 est un schéma électrique d'un circuit d'amplification selon un troisième mode de réalisation de l'invention, et
- la figure 8 est un schéma électrique d'un circuit d'amplification selon un quatrième mode de réalisation de l'invention.

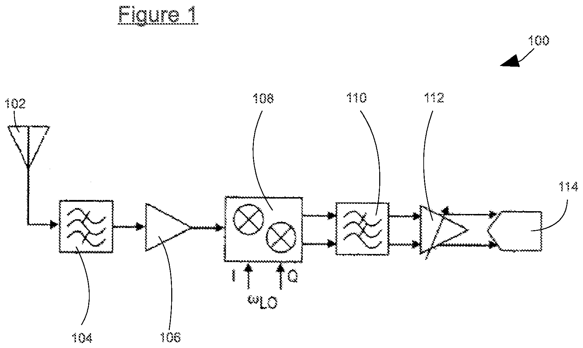

En référence à la figure 1, un exemple 100 de chaîne de réception mettant en œuvre l'invention comporte tout d'abord une antenne 102 destinée à convertir des ondes électromagnétiques en un signal d'antenne.

La chaîne de réception 100 comporte en outre un filtre radiofréquence 104 conçu pour isoler l'information utile dans le signal d'antenne, et un circuit d'amplification 106 pour amplifier le signal filtré.

Le circuit d'amplification 106 est un LNA ayant pour fonction d'amplifier le signal en dégradant le moins possible le signal de l'antenne 102.

La chaîne de réception 100 comporte en outre un mélangeur 108 pour mélanger le signal amplifié avec un signal d'oscillateur local afin d'obtenir un signal mélangé, et un filtre passe bas 110 pour extraire le signal mélangé en bande de base.

La chaîne de réception 100 comporte en outre un amplificateur réglable basse fréquence 112 pour augmenter la dynamique du signal mélangé en bande de base si ce dernier est correctement mélangé, mais de puissance faible. La chaîne de réception 100 comporte un convertisseur analogique numérique 114 pour numériser le signal mélangé en bande de base.

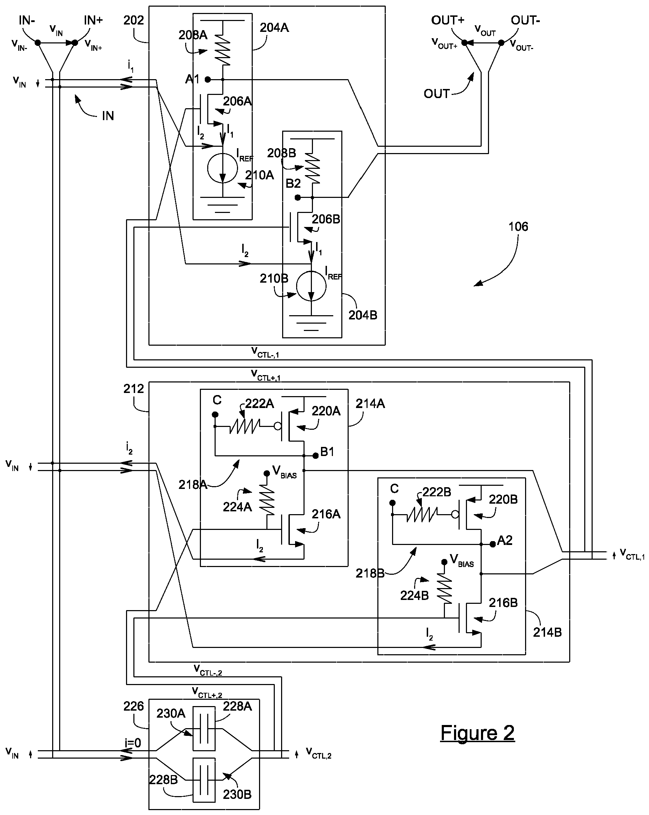

En référence à la figure 2, le circuit d'amplification 106 comporte tout d'abord une entrée IN destinée à recevoir une tension d'entrée $v_{IN}$. L'entrée IN comporte deux bornes d'entrées IN+, IN- pour recevoir la tension d'entrée $v_{IN}$ sous la forme d'une tension différentielle comportant deux potentiels d'entrée opposés $v_{IN+}$ et $v_{IN-}$ de même amplitude et opposés en phase, de sorte que $v_{IN} = v_{IN+} - v_{IN-}$.

Le circuit d'amplification 106 comporte en outre une sortie OUT destinée à présenter une tension de sortie $v_{OUT}$ correspondant à la tension d'entrée $v_{IN}$ amplifiée. La sortie OUT comporte deux bornes de sortie OUT+, OUT- pour fournir la tension de sortie $v_{OUT}$ sous la forme d'une tension différentielle comportant deux potentiels de sortie $v_{OUT+}$ et $v_{OUT-}$, de même amplitude et opposés en phase.

Afin de réaliser cette amplification, le circuit d'amplification 106 comporte tout d'abord un amplificateur principal 202. L'amplificateur principal 202 est connecté, d'une part, à l'entrée IN pour recevoir la tension d'entrée $v_{IN}$ et, d'autre part, à la sortie OUT afin de fournir à cette dernière la tension d'entrée $v_{IN}$ amplifiée. Plus précisément, l'amplificateur principal 202 est conçu pour amplifier la tension d'entrée $v_{IN}$ d'un gain principal $G_1$.

Le gain principal $G_1$ de l'amplificateur principal 202 est variable. Pour le faire varier, l'amplificateur principal 202 est conçu pour recevoir une tension de contrôle $v_{CTL,1}$, également sous forme différentielle et comportant de ce fait des potentiels de contrôle $v_{CTL+,1}$, $v_{CTL-,1}$ de même amplitude et opposés en phase. L'amplificateur principal 202 est ainsi conçu pour que le gain $G_1$ dépende de la tension de contrôle $V_{CTL,1}$.

L'amplificateur principal 202 comporte deux dispositifs d'amplification principaux 204A, 204B, chacun conçu pour fournir l'un respectif des potentiels de sortie $v_{OUT+}$, $v_{OUT-}$ à partir de l'un respectif des potentiels d'entrée $v_{IN+}$, $v_{IN-}$. Plus précisément, le premier dispositif d'amplification principal 204A est conçu pour fournir le potentiel de sortie $v_{OUT+}$ à partir du potentiel d'entrée $v_{IN+}$, tandis que le second dispositif d'amplification principal 204B est conçu pour fournir le potentiel de sortie négatif $v_{OUT-}$ à partir du potentiel d'entrée $v_{IN-}$.

Chaque dispositif d'amplification principal 204A, 204B comporte un transistor à effet de champ 206A, 206B en montage à grille commune, présentant un drain, une source et une grille connectés de la manière suivante.

Chaque dispositif d'amplification principal 204A, 204B comporte une résistance 208A, 208B, de valeur $R_1$, connectant le drain du transistor 206A, 206B à un potentiel fixe $V_{dd}$ (représenté par un trait horizontal). Chaque dispositif d'amplification principal 204A, 204B comporte en outre une source de courant continu 210A, 210B connectant la source du transistor 206A, 206B à une masse électrique du circuit d'amplification 106. Par ailleurs, la grille de chaque transistor 206A, 206B est destinée à recevoir l'un respectif des potentiels de contrôle $v_{CTL+,1}$, $v_{CTL-,1}$.

Chaque borne d'entrée IN+, IN- est connectée à la source de l'un respectif des transistors 206A, 206B, tandis que chaque borne de sortie OUT+, OUT- est connectée au drain de l'un respectif des transistors 206A, 206B.

De cette manière, le dispositif d'amplification principal 204A est conçu pour amplifier le potentiel d'entrée $v_{IN+}$ et pour fournir, en tant que potentiel de sortie $v_{OUT+}$, le potentiel d'entrée $v_{IN+}$ ainsi amplifié. De même, le dispositif d'amplification principal 204B est conçu pour amplifier le potentiel d'entrée $v_{IN-}$ et pour fournir, en tant que potentiel de sortie $v_{OUT-}$, le potentiel d'entrée $v_{IN-}$ ainsi amplifié.

Le circuit d'amplification 106 comporte en outre un amplificateur secondaire 212 conçu pour recevoir la tension d'entrée $v_{IN}$ depuis l'entrée IN, pour amplifier la tension d'entrée $v_{IN}$ d'un gain secondaire $G_2$, et pour fournir à l'amplificateur principal 202, en tant que tension de contrôle principale $v_{CTL,1}$, la tension d'entrée $v_{IN}$ ainsi amplifiée.

Le gain secondaire $G_2$ de l'amplificateur secondaire 212 est variable. Pour le faire varier, l'amplificateur secondaire 212 est conçu pour recevoir une tension de contrôle $v_{CTL,2}$, dont dépend le gain secondaire $G_2$. La tension de contrôle $v_{CTL,2}$ est également sous forme différentielle et comporte de ce fait des potentiels de contrôle $V_{CTL+,2}$, $V_{CTL-,2}$ de même amplitude et opposés en phase.

L'amplificateur secondaire 212 comporte deux dispositifs d'amplification secondaires 214A, 214B, chacun conçu pour fournir l'un respectif des potentiels de contrôle $v_{CTL+,1}$, $v_{CTL-,1}$ à partir de l'un respectif des potentiels d'entrée $v_{IN-}$, $v_{IN+}$. Plus précisément, le premier dispositif d'amplification secondaire 214A est conçu pour fournir le potentiel de contrôle $v_{CTL+,1}$ à partir du potentiel d'entrée $v_{IN-}$, tandis que le second dispositif d'amplification secondaire 214B est conçu pour fournir le potentiel de contrôle $v_{CTL-,1}$ à partir du potentiel d'entrée $v_{IN+}$.

Chaque dispositif d'amplification secondaire 214A, 214B comporte un transistor à effet de champ 216A, 216B en montage à grille commune, présentant un drain, une source et une grille connectés de la manière suivante.

Chaque dispositif d'amplification secondaire 214A, 214B comporte une résistance variable en fréquence 218A, 218B reliant le drain du transistor 216A, 216B au potentiel fixe $V_{dd}$. Chaque résistance variable en fréquence 218A, 218B comporte un transistor à effet de champ 220A, 220B et une résistance 222A, 222B. Le transistor 220A, 220B présente une source reliée au potentiel fixe $V_{dd}$, un drain relié au drain du transistor 216A, 216B de son dispositif d'amplification secondaire 214A, 214B, et une grille reliée au travers de la résistance 222A, 222B à son drain. Chaque dispositif d'amplification secondaire 214A, 214B comporte en outre une résistance 224A, 224B reliant la grille du transistor 216A, 216B à un potentiel fixe $V_{bias}$.

Par ailleurs, la source de chaque transistor 216A, 216B est connectée à l'une respective des bornes d'entrée IN-, IN+ pour recevoir le potentiel correspondant. La grille de chaque transistor 216A, 216B est quant à elle destinée à recevoir l'un respectif des potentiels de contrôle $v_{CTL+,2}$, $V_{CTL-,2}$.

Le dispositif d'amplification secondaire 214A est ainsi conçu pour amplifier le potentiel d'entrée $v_{IN-}$ et pour fournir, en tant que potentiel de contrôle $v_{CTL+1}$, le potentiel d'entrée $v_{IN-}$ ainsi amplifié. De même, le dispositif d'amplification secondaire 214B est conçu pour amplifier le potentiel d'entrée $v_{IN+}$ et pour fournir, en tant que potentiel de contrôle $v_{CTL-,1}$, le potentiel d'entrée $v_{IN+}$ ainsi amplifié.

Le circuit d'amplification 106 comporte en outre trois connexions de neutralisation. Plus précisément, une première connexion de neutralisation relie, au travers d'une capacité non représentée, les conducteurs du circuit d'alimentation 106 présentant le potentiel $v_{CTL-,1}$ aux conducteurs du circuit d'alimentation 106 présentant le potentiel $v_{OUT+}$, afin de neutraliser au moins une partie des capacités parasites présentes le long des conducteurs présentant le potentiel $v_{CTL-,1}$. Cette première connexion de neutralisation est destinée à relier les nœuds A1 et A2 de la figure.

De même, une deuxième connexion de neutralisation relie, au travers d'une capacité non représentée, les conducteurs du circuit d'alimentation 106 présentant le potentiel $v_{CTL+,1}$ aux conducteurs du circuit d'alimentation 106 présentant le potentiel $v_{OUT-}$, afin de neutraliser au moins une partie des capacités parasites présentes le long des conducteurs présentant le potentiel $v_{CTL+,1}$. Cette deuxième connexion de neutralisation est destinée à relier les nœuds B1 et B2 de la figure.

En outre, une troisième connexion de neutralisation relie les grilles respectives des transistors 220A, 220B, afin de neutraliser au moins en partie l'inductance active présente dans les résistances variables en fréquence 218A, 218B. Cette troisième connexion de neutralisation est destinée à relier les nœuds de même nom C de la figure.

Le circuit d'amplification 106 comporte en outre un dispositif d'amplification tertiaire 226 conçu pour amplifier, d'un gain tertiaire $G_3$, une tension d'entrée tertiaire dépendant de la tension d'entrée $v_{in}$, et pour fournir, en tant que tension de contrôle secondaire $v_{CTL,2}$, la tension d'entrée tertiaire ainsi amplifiée. Dans le circuit d'amplification 106, la tension d'entrée tertiaire est la tension d'entrée $v_{in}$.

Plus précisément, l'amplificateur tertiaire 226 comporte deux dispositifs d'amplification tertiaires 228A, 228B chacun conçu pour fournir l'un respectif des potentiels de contrôle $v_{CTL+,2}$, $v_{CTL-,2}$ à partir de l'un respectif des potentiels d'entrée $v_{IN+}$, $v_{IN-}$.

Dans le circuit d'amplification 106, le dispositif d'amplification tertiaire 228A fournit le potentiel de contrôle $v_{CTL+,2}$ à partir du potentiel d'entrée $v_{IN+}$, tandis que le dispositif d'amplification tertiaire 228B fournit le potentiel de contrôle $v_{CTL-,2}$ à partir du potentiel d'entrée $v_{IN-}$.

Chaque dispositif d'amplification tertiaire 228A, 228B comporte une capacité 230A, 230B reliant la borne d'entrée respective IN+, IN- à la grille du transistor 216A, 216B du dispositif d'amplification secondaire 214A, 214B respectif.

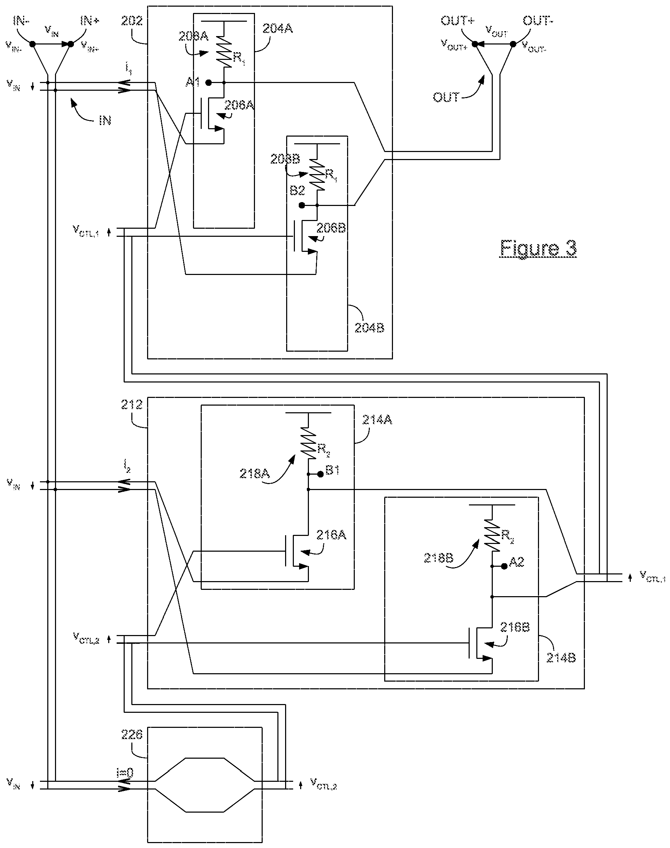

Pour comprendre le fonctionnement du circuit d'amplification 106 lorsqu'il amplifie une tension d'entrée $v_{IN}$ qui est un signal radiofréquence, seuls les signaux électriques radiofréquences sont à considérer. Ainsi, sur la figure 3, tous les composants électriques fournissant un potentiel ou un courant continu ont été omis. De même, comme une capacité de valeur suffisamment élevée pour les signaux électriques radiofréquences considérés se comporte, pour ces signaux électriques radiofréquences, comme une simple liaison, les capacités ont été remplacées par des liaisons directes. Enfin, les résistances variables en fréquence 218A, 218B sont représentées par des résistances simples de valeur $R_2$.

Le fonctionnement du circuit d'amplification 106 va à présent être décrit.

Les transistors à effet de champ sont tout d'abord polarisés par les potentiels continus $V_{dd}$, $V_{BIAS}$ et par les sources de courant continu 210A, 210B générant des courants continus de même valeur $I_{REF}$.

Plus précisément, le courant $I_{REF}$ se divise en deux courants continus $I_1$ et $I_2$ traversant respectivement les transistors 206A et 216B ou 206B et 216A. Ces deux courants $I_1$ et $I_2$ représentent la plus grande partie de la consommation du circuit d'amplification 106.

La polarisation de chaque transistor 206A, 206B est assurée par le choix de la valeur $R_1$ des résistances 208A, 208B, par le choix de la taille du transistor ainsi que par la tension continue source-grille appliquée à ce transistor. Les deux premiers paramètres peuvent être réglés indépendamment des autres composants du circuit. Par contre, la tension de grille de chaque transistor 206A, 206B est directement liée à la tension de drain du transistor 216A, 216B auquel il est relié. Ainsi il existe une dépendance entre la tension source-grille des transistors 206A, 206B et les paramètres de réglage des transistors 216A, 216B.

La polarisation des transistors 216A, 216B est assurée par le choix de leur tension source-grille, par le choix de leur taille et par le choix de la valeur des résistances variables en fréquence 218A, 218B. Les tensions source-grille sont fixées par le potentiel continu $V_{BIAS}$.

En variante non représentée, il est possible de séparer les conditions de polarisation des transistors 206A, 216A (respectivement 206B, 216B) en ajoutant une capacité de liaison entre le drain du transistor 216A (respectivement 216B) et la grille du transistor 206A (respectivement 206B), afin de fixer des potentiels continus différents à ces deux points.

Suite à la polarisation précédente, les transistors 206A, 206B présentent une même transconductance $g_{m1}$, tandis que les transistors 216A, 216B présentent une même transconductance $g_{m2}$.

Par la suite, une tension radiofréquence $v_{IN}$ est reçue sur l'entrée IN du dispositif d'amplification 106.

Un courant $i_2$ sort alors de l'amplificateur secondaire 212 vers la borne IN-. Le courant $i_2$ vaut :

$$i_2 = g_{m2}\left(v_{CTL+,\,2} - v_{IN-}\right) = 2g_{m2}\,v_{IN+}$$

puisque

$$v_{CTL+,\,2} = v_{IN+}$$

et

$$v_{IN-} = -v_{IN+}$$

Le même courant $i_2$ entre dans l'amplificateur 212 depuis la borne IN+.

Ainsi, en fonctionnement, l'amplificateur secondaire 212 présente une admittance d'entrée $g_2$ non nulle valant :

$$g_2 = \frac{i_2}{v_{IN}} = \frac{i_2}{2v_{IN+}} = g_{m2}$$

En pratique, cela signifie que le circuit d'amplification est dimensionné pour que l'admittance $g_2$ ait une valeur d'au moins 1 millisiemens, de préférence d'au moins 10 millisiemens, et de préférence encore d'au moins 20 millisiemens si l'on cherche à considérablement abaisser l'impédance d'entrée.

En outre, un courant $i_1$ sort de l'amplificateur principal 202 vers la borne IN-. Le courant $i_1$ vaut :

$$i_1 = g_{m1}\left(v_{CTL-,\,1} - v_{IN-}\right)$$

soit :

$$i_1 = g_{m1}\left(1 + 2R_2\,g_{m2}\right)v_{IN+}$$

puisque

$$v_{IN-} = -v_{IN+}$$

et

$$v_{CTL-,\,1} = 2R_2\,g_{m2}\,v_{IN+}$$

Le même courant $i_1$ entre dans l'amplificateur 212 depuis la borne IN+.

Ainsi, en fonctionnement, l'amplificateur principal 202 présente une admittance d'entrée $g_1$ non nulle valant :

$$g_1 = \frac{i_1}{v_{\text{IN}}} = \frac{1}{2}\, g_{m1}\left(1 + 2R_2\, g_{m2}\right)$$

En pratique, cela signifie que le circuit d'amplification 106 est dimensionné pour que l'admittance $g_1$ ait une valeur d'au moins 1 millisiemens, de préférence d'au moins 10 millisiemens, et de préférence encore d'au moins 20 millisiemens si l'on cherche à considérablement abaisser l'impédance d'entrée.

Ainsi, le circuit d'amplification 106 présente une admittance d'entrée g valant :

$$g = g_1 + g_2 = \frac{1}{2}\, g_{m1}\left(1 + 2R_2\, g_{m2}\right) + g_{m2} = \underline{g_1}\left(1 + 2R_2\, g_{m2}\right) + g_{m2}$$

avec $\underline{g_1} = \frac{1}{2}\, g_{m1}$ l'admittance de l'amplificateur principal 202 en l'absence d'amplificateur secondaire 212 ($g_{m2}$ nul). Il est ainsi possible d'obtenir une admittance d'entrée élevée et donc une impédance d'entrée faible (de préférence 50 $\Omega$), sans que la consommation électrique soit élevée car les transconductances $g_{m1}$ et $g_{m2}$ restent modérées.

Plus précisément, le montage proposé permet d'ajouter deux contributions supplémentaires à l'admittance d'entrée $g_1$ que présenterait l'amplificateur principal 202 en l'absence d'amplificateur secondaire 212.

La première contribution est formée du facteur $(1 + 2R_2g_{m2})$ qui provient de l'augmentation de gain apportée par la présence de l'amplificateur secondaire 212.

La seconde contribution est formée du terme $g_{m2}$ qui provient de la génération du courant $i_2$, et qui bénéficie de la CCCT (l'amplificateur tertiaire 226).

Par ailleurs, l'impédance d'entrée du circuit d'amplification 106 présente également une partie imaginaire, notamment une partie inductive, issue d'un effet gyrateur d'impédance. Cet effet provoque l'apparition d'une partie imaginaire de type inductif dans l'admittance d'entrée, cette partie imaginaire étant proportionnelle à l'admittance des résistances variables en fréquence 218A, 218B, à cause de la présence de capacités grille-source non nulles dans les transistors 206A, 206B. De préférence, cette partie inductive est avantageusement exploitée avec une capacité parasite en entrée afin d'augmenter la largeur de la gamme de fréquences sur laquelle le circuit d'amplification 106 est adapté.

Le gain $G_1$ peut être déterminé de la manière suivante.

L'amplificateur tertiaire 226 fournit une tension de contrôle secondaire $v_{\text{CTL},2}$ valant $-G_3 \cdot v_{\text{IN}}$, avec $G_3$ valant 1.

L'amplificateur secondaire 212 fournit une tension de contrôle principale $V_{\text{CTL},1}$ valant $G_2 \cdot v_{\text{IN}}$, avec $G_2$ valant :

$$G_2 = \left(1 + G_3\right)R_2\, g_{m2} = \left(1 + G_3\right)\underline{G_2}$$

avec $\underline{G_2} = R_2 g_{m2}$ le gain secondaire sans amplification tertiaire, c'est-à-dire lorsque $G_3 = 0$.

L'amplificateur principal 202 fournit une tension de sortie $v_{\text{OUT}}$ valant :

$$v_{OUT} = G_1\, v_{\text{IN}}$$

avec $G_1$ valant :

$$G_1 = \left(1 + G_2\right)R_1\, g_{m1}$$

ou bien

$$G_1 = \left(1 + G_2\right)\underline{G_1}$$

avec $\underline{G_1} = R_1 g_{m1}$ le gain principal sans amplification secondaire, c'est-à-dire lorsque $G_2 = 0$.

Le gain principal peut encore s'écrire :

$$G_1 = \underline{G_1} + \left(1 + G_3\right)\underline{G_1}\,\underline{G_2}$$

Comme $G_3$ vaut 1, le gain principal $G_1$ vaut :

$$\underline{G_1} = \underline{G_1} + 2\,\underline{G_1}\,\underline{G_2} = \underline{G_1}\left(1 + 2\,\underline{G_2}\right)$$

Ainsi, le gain $\underline{G_1}$ est augmenté d'un facteur $(1 + 2\cdot\underline{G_2})$ où $\underline{G_2}$ est le gain de l'amplificateur secondaire seul, lui-même augmenté d'un facteur de deux grâce à la présence de la CCCT (l'amplificateur tertiaire 226).

On notera que les calculs de gain et d'admittance précédents sont réalisés à partir d'une modélisation simple des composants du circuit. Plus précisément, cette modélisation simplifiée néglige l'impact des capacités parasites et de conductances finies des transistors utilisés dans le circuit.

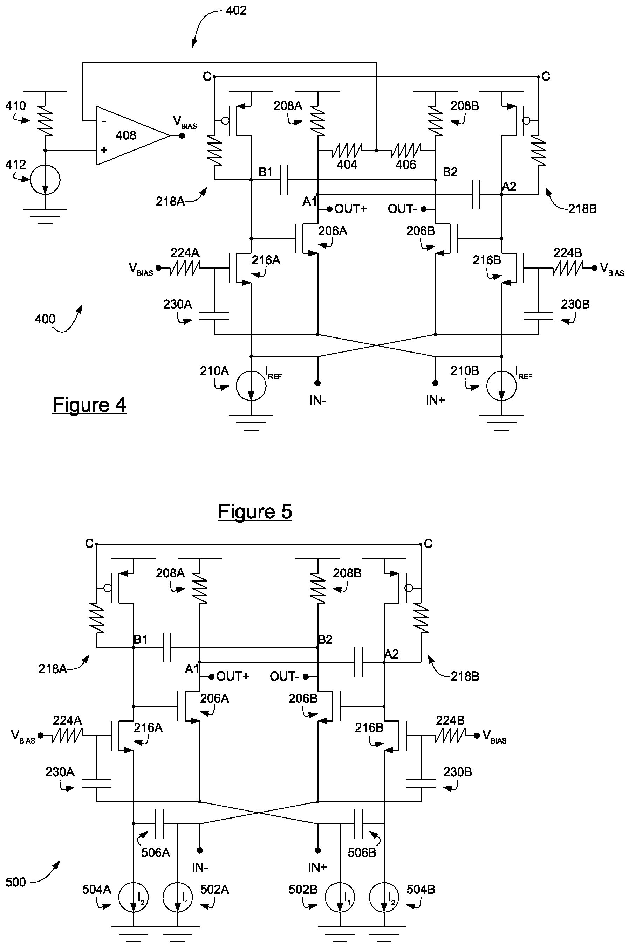

En référence à la figure 4, une première variante 400 du circuit d'amplification 106 est illustrée, cette variante 400 pouvant être utilisée dans la chaîne de réception 100 à la place du circuit d'amplification 106.

Cette variante 400 se distingue du circuit d'amplification 106 en ce qu'elle comporte, en plus de tous les composants du circuit d'amplification 106, une boucle de régulation continue 402.

La boucle de régulation continue 402 comporte deux résistances 404, 406 l'une à la suite de l'autre reliant entre eux les drains des transistors 206A, 206B.

La boucle de régulation continue 402 comporte en outre un amplificateur opérationnel 408 présentant une sortie reliée au potentiel fixe $V_{BIAS}$, une entrée négative reliée entre les résistances 404, 406 et une entrée positive connectée comme cela sera expliqué ci-dessous.

La boucle de régulation continue 402 comporte en outre une résistance 410 de valeur $R_1$ reliant l'entrée positive de l'amplificateur opérationnel au potentiel fixe $V_{dd}$ et une source de courant continue 412 reliant l'entrée positive de l'amplificateur opérationnel 408 à la masse électrique et générant un courant de valeur $I_1$ vers la masse électrique.

Grâce à la boucle de régulation continue 402, la répartition du courant $I_{REF}$ entre $I_1$ et $I_2$ est moins sensible au potentiel continu appliqué sur la grille des transistors à effet de champ 216A, 216B que dans le circuit d'amplification 106.

En référence à la figure 5, une seconde variante 500 du circuit d'amplification 106 est illustré, cette variante 500 pouvant être utilisée dans la chaîne de réception 100 à la place du circuit d'amplification 106.

Cette variante 500 se distingue du circuit d'amplification 106 en ce qu'elle comporte des sources de courant continu 502A, 502B, 504A, 504B pour générer de manière séparée les courants $I_1$ et $I_2$.

Plus précisément, la source de courant continu 502A relie l'entrée IN- à la masse et génère le courant $I_1$ vers la masse. La source de courant continu 504A relie la source du transistor à effet de champ 216A à la masse et génère le courant $I_2$ vers la masse.

Afin que le potentiel $v_{IN+}$ soit toujours appliqué à la source du transistor 216A sans que la source de courant 502A n'influence le courant statique du transistor 216A, la variante 500 comporte en outre une capacité 506A reliant la source de courant continu 504A à l'entrée IN- et à la source de courant continu 502A.

De manière symétrique, la source de courant continu 502B relie l'entrée IN+ à la masse et génère le courant $I_1$ vers la masse. La source de courant continu 504B relie la source du transistor 216B à la masse et génère le courant $I_2$ vers la masse. La variante 500 comporte en outre une capacité 506B reliant la source de courant continu 504B à l'entrée IN+ et à la source de courant continu 502B.

Ainsi, il est possible de régler les courants $I_1$ et $I_2$ indépendamment l'un de l'autre.

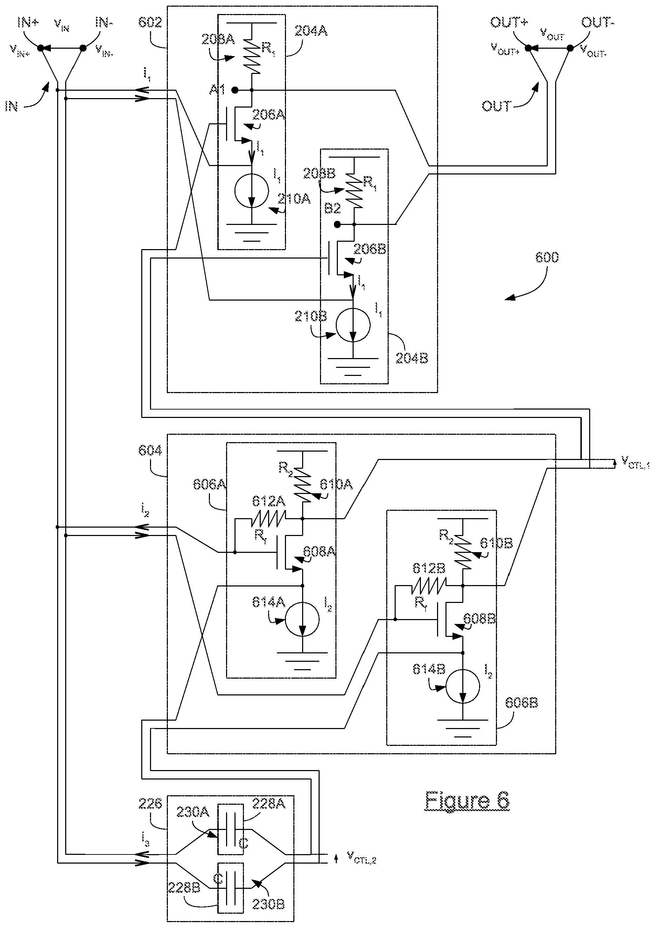

En référence à la figure 6, un circuit d'amplification 600 selon un deuxième mode de réalisation de l'invention est illustré. Cette variante 600 peut être utilisée dans la chaîne de réception 100 à la place du circuit d'amplification 106.

Le circuit d'amplification 600 comporte trois amplificateurs comme dans le circuit d'amplification 106, dont seul le second est différent.

Ainsi, l'amplificateur secondaire, qui porte à présent la référence 604, comporte deux dispositifs d'amplification secondaires 606A, 606B, chacun conçu pour fournir l'un respectif des potentiels de contrôle $v_{CTL+1}$, $v_{CTL-,1}$ à partir de l'un respectif des potentiels d'entrée $v_{IN+}$, $v_{IN-}$. Plus précisément, le premier dispositif d'amplification secondaire 606A est conçu pour fournir le potentiel de contrôle $v_{CTL+,1}$ à partir du potentiel d'entrée $v_{IN+}$, tandis que le second dispositif d'amplification secondaire 606B est conçu pour fournir le potentiel de contrôle $v_{CTL-,1}$ négatif à partir du potentiel d'entrée négatif $v_{IN-}$.

Chaque dispositif d'amplification secondaire 606A, 606B comporte un transistor à effet de champ 608A, 608B en montage à grille commune présentant une même transconductance $g_{m2}$ et avec une boucle de rétroaction résistive. Plus précisément, chaque transistor 608A, 608B présente un drain, une source et une grille connectés de la manière suivante.

Chaque dispositif d'amplification secondaire 606A, 606B comporte une résistance 610A, 610B de valeur $R_2$ reliant le drain du transistor 608A, 608B au potentiel fixe $V_{dd}$, ainsi qu'une résistance 612A, 612B de valeur $R_f$ reliant le drain du transistor 608A, 608B à la grille et formant la boucle de rétroaction résistive.

Par ailleurs, la grille de chaque transistor 608A, 608B est connectée à l'une respective des bornes d'entrée IN+, IN- pour recevoir le potentiel correspondant. La source de chaque transistor 608A, 608B est quant à elle destinée à recevoir l'un respectif des potentiels de contrôle $v_{CTL+,2}$, $v_{CTL-,2}$.

Enfin, chaque dispositif d'amplification secondaire 606A, 606B comporte une source de courant continu 614A, 614B reliant la source du transistor 608A, 608B à la masse électrique, et générant le courant continu $I_2$ vers la masse électrique servant à la polarisation du transistor 608A, 608B.

Par ailleurs, suite à la modification de l'amplificateur secondaire 212, les sources de courant continu 210A, 210B de l'amplificateur principal 202 génèrent à présent le courant $I_1$ de polarisation des transistors 206A, 206B, mais plus le courant $I_2$ de polarisation.

En outre, toujours suite à la modification de l'amplificateur secondaire 212, un courant $i_3$ circule entre l'amplificateur tertiaire 226 et l'entrée IN.

Après polarisation, les transistors 206A, 206B présentent une transconductance valant $g_{m1}$, tandis que les transistors 608A, 608B présentent une transconductance valant $g_{m2}$.

Dans ce mode de réalisation, toujours en utilisant une modélisation simple des composants du circuit, l'admittance d'entrée de l'amplificateur principal 602 vaut :

$$g_1 = \frac{i_1}{v_{IN}} = \frac{g_{m1}}{2}\left[1 + \frac{2g_{m2}R_2 - g_f R_2}{1 + g_f R_2}\right]$$

avec :

$$g_f = \frac{1}{R_f}$$

En outre, l'admittance d'entrée de l'amplificateur secondaire 604 vaut :

$$g_2 = \frac{i_2}{v_{IN}} = \frac{g_f}{2}\left[1 + \frac{2g_{m2}R_2 - g_f R_2}{1 + g_f R_2}\right]$$

En outre, l'admittance d'entrée de l'amplificateur tertiaire 226 vaut :

$$g_3 = \frac{i_3}{v_{IN}} = g_{m2}$$

Ainsi, l'admittance d'entrée du circuit d'amplification 600 vaut :

$$g = g_1 + g_2 + g_3 = \frac{(g_{m1} + g_f)}{2}\left[1 + \frac{2g_{m2}R_2 - g_f R_2}{1 + g_f R_2}\right] + g_{m2}$$

Par ailleurs, le gain $G_1$ de l'amplificateur principal 602 vaut :

$$G_1 = \frac{v_{OUT}}{v_{IN}} = (g_{m1} + g_f)\left[1 + \frac{2g_{m2}R_2 - g_f R_2}{1 + g_f R_2}\right]$$

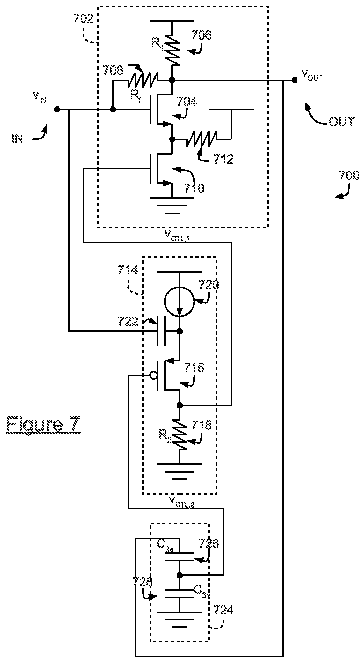

En référence à la figure 7, un circuit d'amplification 700 selon un autre mode de réalisation de l'invention est illustré. Cette variante 700 peut être utilisée dans la chaîne de réception 100 à la place du circuit d'amplification 106.

Le circuit d'amplification 700 comporte trois amplificateurs comme pour le circuit d'amplification 106, mais est conçu pour recevoir la tension d'entrée $v_{IN}$ sous forme monopotentielle et pour fournir la tension de sortie $v_{OUT}$ également sous forme monopotentielle.

Ainsi, le circuit d'amplification 700 comporte tout d'abord une entrée IN destinée à recevoir la tension d'entrée

$v_{IN}$. L'entrée IN comporte une seule borne d'entrée pour recevoir la tension d'entrée $v_{IN}$ sous la forme d'une tension monopotentielle.

Le circuit d'amplification 700 comporte en outre une sortie OUT destinée à présenter une tension de sortie $v_{OUT}$ correspondant à la tension d'entrée $v_{IN}$ amplifiée. La sortie OUT comporte une seule borne de sortie pour fournir la tension de sortie $v_{OUT}$ sous la forme d'une tension monopotentielle.

Afin de réaliser cette amplification, le circuit d'amplification 700 comporte tout d'abord un amplificateur principal 702. L'amplificateur principal 702 est connecté, d'une part, à l'entrée IN pour recevoir la tension d'entrée $v_{IN}$ et, d'autre part, à la sortie OUT afin de fournir à cette dernière la tension d'entrée $v_{IN}$ amplifiée. Plus précisément, l'amplificateur principal 702 est conçu pour amplifier la tension d'entrée $v_{IN}$ d'un gain principal $G_1$.

Le gain principal $G_1$ de l'amplificateur principal 702 est variable. Pour le faire varier, l'amplificateur principal 702 est conçu pour recevoir une tension de contrôle $v_{CTL,1}$, également sous forme monopotentielle. L'amplificateur principal 702 est ainsi conçu pour que le gain $G_1$ dépende de la tension de contrôle $v_{CTL,1}$.

L'amplificateur principal 702 comporte un transistor à effet de champ 704 en montage à source commune avec une boucle de rétroaction résistive. Plus précisément, le transistor 704 présente un drain, une source et une grille connectés de la manière suivante.

L'amplificateur principal 702 comporte une résistance 706 reliant le drain du transistor 704 au potentiel fixe $V_{dd}$. L'amplificateur principal 704 comporte en outre une résistance 708 reliant le drain du transistor 704 à sa grille, et formant la boucle de rétroaction résistive. Par ailleurs, la grille du transistor 704 est connectée à l'entrée IN pour recevoir la tension d'entrée $v_{IN}$. L'amplificateur principal 702 comporte en outre une résistance variable formée, d'une part, d'un transistor à effet de champ 710 présentant un drain relié à la source du transistor 704, d'une source relié à la masse électrique, et, d'autre part, d'une résistance 712 reliant le drain du transistor 710 au potentiel fixe $V_{dd}$. La résistance variable est destinée à recevoir la tension de contrôle $V_{CTL,1}$ sur la grille du transistor 710 pour faire varier la résistance.

Le circuit d'amplification 700 comporte en outre un amplificateur secondaire 714 conçu pour recevoir la tension d'entrée $v_{IN}$ depuis l'entrée IN, amplifier la tension d'entrée $v_{IN}$ d'un gain secondaire $G_2$, et fournir à l'amplificateur principal 702, en tant que tension de contrôle $v_{CTL,1}$, la tension d'entrée $v_{IN}$ ainsi amplifiée.

Le gain secondaire $G_2$ de l'amplificateur secondaire 714 est variable. Pour le faire varier, l'amplificateur secondaire 714 est conçu pour recevoir une tension de contrôle $v_{CTL,2}$, dont dépend le gain secondaire $G_2$. La tension de contrôle $v_{CTL,2}$ est également sous forme monopotentielle.

L'amplificateur secondaire 714 comporte un transistor à effet de champ 716 en montage à grille commune. Le transistor 716 présente un drain, une source et une grille connectés de la manière suivante.

L'amplificateur secondaire 714 comporte une résistance 718 de valeur $R_3$ reliant le drain du transistor à effet de champ 716 à la masse électrique.

L'amplificateur secondaire 714 comporte en outre une source de courant continu 720 reliant la source du transistor 716 au potentiel fixe $V_{dd}$, et générant un courant $I_2$ depuis le potentiel fixe $V_{dd}$ et vers la source du transistor à effet de champ 716.

L'amplificateur secondaire 714 comporte en outre une capacité de liaison 722 reliant la source du transistor 716 à l'entrée IN afin de recevoir la tension d'entrée $v_{IN}$.

Le circuit d'amplification 700 comporte en outre un dispositif d'amplification tertiaire 724 conçu pour amplifier une tension d'entrée tertiaire dépendant de la tension d'entrée $v_{in}$ d'un gain tertiaire $G_3$, et pour fournir, en tant que tension de contrôle $v_{CTL,2}$, la tension d'entrée tertiaire ainsi amplifiée. Dans le circuit d'amplification 700, la tension d'entrée tertiaire est la tension de sortie $v_{OUT}$.

Plus précisément, l'amplificateur tertiaire 724 comporte deux capacités 726, 728 montées en pont diviseur capacitif. Les deux capacités 726, 728 sont ainsi disposées l'une à la suite de l'autre et relient la sortie OUT à la masse électrique. En outre, la grille du transistor 716 est reliée entre les deux capacités 726, 728 pour recevoir la tension de contrôle $V_{CTL,2}$.

Après polarisation, le transistor 704 présente une transconductance valant $g_{m1a}$, le transistor 710 présente une transconductance valant $g_{m1b}$ et le transistor 716 présente une transconductance valant $g_{m2}$.

Toujours en utilisant une modélisation simple des composants du circuit, le gain $G_1$ de l'amplificateur principal 702 vaut :

$$G_1 = \frac{v_{OUT}}{v_{IN}} = \frac{-\left(g_{m1a} - g_f\right)\left(g_{m1a} + g_2\right) - g_{m1a}\left(g_{m1b}\, g_{m2}\, a - g_{m1a}\right)}{\left(g_1 + g_f\right)\left(g_{m1a} + g_2\right) - g_{m1a}\left(g_{m1b}\, g_{m2}\, R_3\, a\right)}$$

$$a = \frac{C_{3a}}{C_{3a} + C_{3b}}, \quad g_2 = \frac{1}{R_2} \quad \text{et} \quad g_f = \frac{1}{R_f}.$$

En outre, l'admittance d'entrée de l'amplificateur principal vaut :

$$g_1 = \frac{i_1}{v_{IN}} = g_f \left(1 - G_1\right)$$

En outre, l'admittance d'entrée de l'amplificateur secondaire 714 vaut :

$$g_2 = \frac{i_2}{v_{IN}} = g_{m2} \left(1 - a G_1\right)$$

Ainsi, l'admittance d'entrée du circuit d'amplification 700 vaut :

$$g = g_1 + g_2 = g_f \left(1 - G_1\right) + g_{m2} \left(1 - a G_1\right)$$

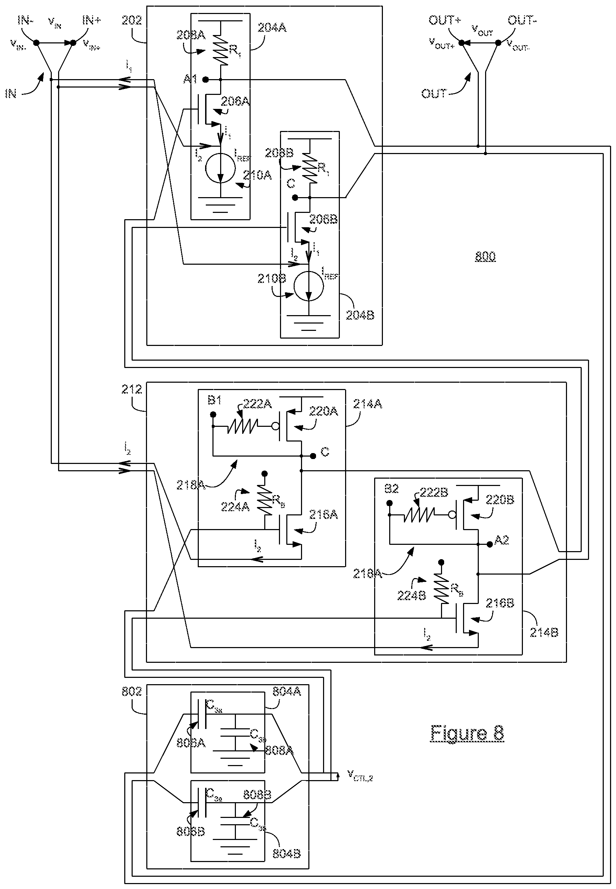

En référence à la figure 8, un circuit d'amplification 800 selon un autre mode de réalisation de l'invention est illustré. Cette variante 800 peut être utilisée dans la chaîne de réception 100 à la place du circuit d'amplification 106.

Le circuit d'amplification 800 est identique au circuit d'amplification 106, si ce n'est pour l'amplificateur tertiaire qui porte à présent la référence 802.

L'amplificateur tertiaire 802 est conçu pour amplifier une tension d'entrée tertiaire dépendant de la tension d'entrée $v_{IN}$ d'un gain tertiaire $G_3$, et pour fournir, en tant que tension de contrôle $v_{CTL,2}$, la tension d'entrée tertiaire ainsi amplifiée. Dans le circuit d'amplification 800, la tension d'entrée tertiaire est la tension de sortie $v_{OUT}$.

Plus précisément, l'amplificateur tertiaire 802 comporte deux dispositifs d'amplification tertiaires 804A, 804B chacun conçu pour fournir l'un respectif des potentiels de contrôle secondaire $v_{CTL+,2}$, $v_{CTL-,2}$ à partir de l'un respectif des potentiels de sortie $v_{OUT+}$, $v_{OUT-}$. Dans le circuit d'amplification 800, le dispositif d'amplification tertiaire 804A fournit le potentiel de contrôle secondaire $v_{CTL+,2}$ à partir du potentiel de sortie $v_{OUT+}$, tandis que le dispositif d'amplification tertiaire 804B fournit le potentiel de contrôle secondaire $v_{CTL-,2}$ à partir du potentiel de sortie $v_{OUT-}$.

Chaque dispositif d'amplification tertiaire 804A, 804B comporte deux capacités 806A, 808A, respectivement 806B, 808B, de valeurs respectives $C_{3a}$ et $C_{3b}$, montées en pont diviseur capacitif. Les deux capacités 806A, 808A, respectivement 806B, 808B, sont ainsi disposées l'une à la suite de l'autre et relient la sortie OUT+, respectivement OUT-, à la masse électrique. En outre, la grille du transistor 216A, respectivement 216B, est reliée entre les deux capacités 806A, 808A, respectivement 806B, 808B, pour recevoir le potentiel de contrôle $v_{CTL+,2}$, respectivement $V_{CTL-,2}$.

Après polarisation, les transistors 206A, 206B présentent une transconductance valant $g_{m1}$, tandis que les transistors 216A, 216B présentent une transconductance valant $g_{m2}$. En outre, les résistances variables en fréquence 218A, 218B valent $R_2$.

Toujours en utilisant une modélisation simple des composants du circuit, l'admittance d'entrée de l'amplificateur principal vaut :

$$g_1 = \frac{i_1}{v_{IN}} = \frac{g_{m1}}{2} \left(1 + g_{m2} R_2 \left(1 + a G_1\right)\right)$$

avec $a = \frac{C_{3a}}{C_{3a} + C_{3b}}$ et $G_1$ le gain de l'amplificateur principal.

L'admittance d'entrée de l'amplificateur secondaire vaut :

$$g_2 = \frac{i_2}{v_{IN}} = \frac{g_{m2}}{2} \left(1 + a G_1\right)$$

Ainsi, l'admittance d'entrée du circuit d'amplification vaut :

$$g = g_1 + g_2 = \frac{g_{m1}}{2}\left(1 + g_{m2}R_2\left(1 + aG_1\right)\right) + \frac{g_{m2}}{2}\left(1 + aG_1\right)$$

Par ailleurs, le gain $G_1$ de l'amplificateur principal vaut :

$$G_1 = g_{m1}R_1\frac{\left(1 + g_{m2}R_2\right)}{1 - g_{m1}g_{m2}R_2R_1a}$$

Il apparaît clairement qu'un circuit d'amplification selon l'invention permet d'obtenir un rapport admittance d'entrée/consommation électrique très intéressant.

En particulier, les exemples donnés ci-dessus décrivent le cas où l'amplificateur secondaire comporte un transistor sur la source duquel chaque potentiel d'entrée ($V_{IN}$, ou bien $V_{IN-}$ et $V_{IN+}$ suivant les cas) est reçu, ce qui participe à l'obtention de l'admittance d'entrée élevée (c'est-à-dire supérieure à 1 mS) de l'amplificateur secondaire.

Par ailleurs, l'invention n'est pas limitée aux modes de réalisation décrits précédemment, mais au contraire définie par les revendications qui suivent.

Il apparaîtra en effet à l'homme de l'art que diverses modifications peuvent être apportées aux modes de réalisation décrits ci-dessus, à la lumière de l'enseignement qui vient de lui être divulgué.

**Revendications**

**1.** Circuit d'amplification, comportant :

- une entrée (IN) destinée à recevoir une tension d'entrée ($v_{IN}$),
- une sortie (OUT) destinée à présenter une tension de sortie ($v_{OUT}$),
- un amplificateur principal (202, 602, 702) conçu pour :

+ recevoir la tension d'entrée ($v_{IN}$) depuis l'entrée (IN),
+ recevoir une tension de contrôle principale ($v_{CTL,1}$),
+ amplifier la tension d'entrée ($v_{IN}$) d'un gain principal ($G_1$) en amplifiant une différence entre la tension d'entrée ($V_{IN}$) et la tension de contrôle principale ($v_{CTL,1}$), la tension de sortie ($v_{OUT}$) correspondant à la tension d'entrée ($v_{IN}$) ainsi amplifiée,
+ fournir la tension de sortie ($v_{OUT}$) à la sortie (OUT),

- un amplificateur secondaire (212, 604, 714) conçu pour :

+ recevoir la tension d'entrée ($v_{IN}$) depuis l'entrée (IN),
+ amplifier la tension d'entrée ($v_{IN}$) d'un gain secondaire ($G_2$), la tension de contrôle principale ($v_{CTL,1}$) correspondant à la tension d'entrée ($v_{IN}$) ainsi amplifiée ,
+ fournir la tension de contrôle principale ($v_{CTL,1}$) à l'amplificateur principal ($A_1$),

où l'amplificateur secondaire (212, 604, 714) est conçu pour présenter en fonctionnement une admittance d'entrée ($g_2$) d'au moins 1 millisiemens, l'amplificateur secondaire (212, 604, 714) est conçu pour recevoir une tension de contrôle secondaire ($v_{CTL,2}$) et pour amplifier la tension d'entrée ($v_{IN}$) du gain secondaire ($G_2$) en amplifiant une différence entre la tension d'entrée ($v_{IN}$) et la tension de contrôle secondaire ($v_{CTL,2}$), et où le circuit d'amplification comporte en outre un amplificateur tertiaire (226, 724, 802) conçu pour amplifier une tension d'entrée tertiaire dépendant de la tension d'entrée ($V_{in}$) d'un gain tertiaire ($G_3$), la tension de contrôle secondaire ($v_{CTL,2}$) correspondant à la tension d'entrée tertiaire ainsi amplifiée.

**2.** Circuit d'amplification selon la revendication 1, dans lequel l'amplificateur principal (202, 602, 702) est conçu pour présenter en fonctionnement une admittance d'entrée ($g_1$) d'au moins 1 millisiemens.

**3.** Circuit d'amplification selon la revendication 1 ou 2, dans lequel le gain secondaire ($G_2$) est strictement supérieur en valeur absolue à 1.

**4.** Circuit d'amplification selon l'une quelconque des revendications 1 à 3, dans lequel le gain tertiaire ($G_3$) est égal en valeur absolue à 1.

**5.** Circuit d'amplification selon l'une quelconque des revendications 1 à 3, dans lequel le gain tertiaire est strictement inférieur en valeur absolue à 1.

**6.** Circuit d'amplification selon l'une quelconque des revendications 1 à 5, dans lequel la tension d'entrée tertiaire est la tension d'entrée ($V_{IN}$).

**7.** Circuit d'amplification selon l'une quelconque des revendications 1 à 5, dans lequel la tension d'entrée tertiaire est la tension de sortie ($V_{OUT}$).

**8.** Circuit d'amplification selon l'une des revendications 1 à 7, dans lequel la tension d'entrée ($v_{IN}$) et/ou la tension de sortie ($v_{OUT}$) sont/est sous forme différentielle.

**9.** Circuit d'amplification selon l'une des revendications 1 à 8, dans lequel l'amplificateur principal (202, 602, 702) comporte un transistor à effet de champ en montage à grille commune comportant une source, une grille et une transconductance, et dans lequel le transistor à effet de champ en montage à grille commune est conçu pour recevoir un potentiel de la tension d'entrée sur sa source et un potentiel de la tension de contrôle principale sur sa grille de sorte que l'amplification de la différence entre la tension d'entrée et la tension de contrôle principale dépende de sa transconductance.

**10.** Chaîne de réception, comportant :

- une antenne conçue pour recevoir un signal radiofréquence et le convertir en une tension d'antenne,
- un circuit d'amplification selon l'une des revendications 1 à 9, conçu pour recevoir une tension d'entrée ($v_{IN}$) provenant de la tension d'antenne.

**Patentansprüche**

**1.** Verstärkungsschaltung, umfassend:

- einen Eingang (IN), der dazu bestimmt ist, eine Eingangsspannung ($v_{IN}$) zu empfangen,
- einen Ausgang (OUT), der dazu bestimmt ist, eine Ausgangsspannung ($V_{OUT}$) aufzuweisen,
- einen Hauptverstärker (202, 602, 702), der dafür konzipiert ist:

-- die Eingangsspannung ($v_{IN}$) vom Eingang (IN) zu empfangen,
-- eine Hauptsteuerspannung ($V_{CTL,1}$) zu empfangen,
-- die Eingangsspannung ($v_{IN}$) durch Verstärken einer Differenz zwischen der Eingangsspannung ($v_{IN}$) und der Hauptsteuerspannung ($V_{CTL,1}$) um eine Hauptverstärkung ($G_1$) zu verstärken, wobei die Ausgangsspannung ($V_{OUT}$) der so verstärkten Eingangsspannung ($v_{IN}$) entspricht,
-- die Ausgangsspannung ($V_{OUT}$) dem Ausgang (OUT) bereitzustellen,

- einen sekundären Verstärker (212, 604, 714), der dafür konzipiert ist:

-- die Eingangsspannung ($v_{IN}$) vom Eingang (IN) zu empfangen,
-- die Eingangsspannung ($v_{IN}$) um eine sekundäre Verstärkung ($G_2$) zu verstärken, wobei die Hauptsteuerspannung ($V_{CTL,1}$) der so verstärkten Eingangsspannung ($v_{IN}$) entspricht,
-- die Hauptsteuerspannung ($V_{CTL,1}$) dem Hauptverstärker ($A_1$) bereitzustellen,

wobei der sekundäre Verstärker (212, 604, 714) dafür konzipiert ist, im Betrieb eine Eingangsadmittanz ($g_2$) von mindestens 1 Millisiemens aufzuweisen, wobei der sekundäre Verstärker (212, 604, 714) dafür konzipiert ist, eine sekundäre Steuerspannung ($V_{CTL,2}$) zu empfangen und dafür, die Eingangsspannung ($v_{IN}$) durch Verstärken einer Differenz zwischen der Eingangsspannung ($v_{IN}$) und der sekundären Steuerspannung ($V_{CTL,2}$) um die sekundäre Verstärkung ($G_2$) zu verstärken, und wobei die Verstärkungsschaltung weiter einen tertiären Verstärker (226, 724, 802) umfasst, der dafür konzipiert ist, eine tertiäre Eingangsspannung, die von der Eingangsspannung ($V_{in}$) abhängig ist, um eine tertiäre Verstärkung ($G_3$) zu verstärken, wobei die sekundäre Steuerspannung ($V_{CTL,2}$) der so verstärkten tertiären Eingangsspannung entspricht.

2. Verstärkungsschaltung nach Anspruch 1, wobei der Hauptverstärker (202, 602, 702) dafür konzipiert ist, im Betrieb eine Eingangsadmittanz ($g_1$) von mindestens 1 Millisiemens aufzuweisen.

3. Verstärkungsschaltung nach Anspruch 1 oder 2, wobei die sekundäre Verstärkung ($G_2$) im Absolutwert streng größer als 1 ist.

4. Verstärkungsschaltung nach einem der Ansprüche 1 bis 3, wobei die tertiäre Verstärkung ($G_3$) im Absolutwert gleich 1 ist.

5. Verstärkungsschaltung nach einem der Ansprüche 1 bis 3, wobei die tertiäre Verstärkung im Absolutwert streng kleiner als 1 ist.

6. Verstärkungsschaltung nach einem der Ansprüche 1 bis 5, wobei die tertiäre Eingangsspannung die Eingangsspannung ($v_{IN}$) ist.

7. Verstärkungsschaltung nach einem der Ansprüche 1 bis 5, wobei die tertiäre Eingangsspannung die Ausgangsspannung ($V_{OUT}$) ist.

8. Verstärkungsschaltung nach einem der Ansprüche 1 bis 7, wobei die Eingangsspannung ($v_{IN}$) und/oder die Ausgangsspannung ($V_{OUT}$) in differentieller Form vorliegt/vorliegen.

9. Verstärkungsschaltung nach einem der Ansprüche 1 bis 8, wobei der Hauptverstärker (202, 602, 702) einen Feldeffekttransistor in Anbringung mit einem gemeinsamen Gate umfasst, der eine Quelle, ein Gate und eine Transkonduktanz umfasst, und wobei der Feldeffekttransistor in Anbringung mit einem gemeinsamen Gate dafür konzipiert ist, an seiner Quelle ein Potential der Eingangsspannung, und an seinem Gate ein Potential der Hauptsteuerspannung zu empfangen, sodass die Verstärkung der Differenz zwischen der Eingangsspannung und der Hauptsteuerspannung von seiner Transkonduktanz abhängt.

10. Empfangskette, umfassend:

- eine Antenne, die dafür konzipiert ist, ein Hochfrequenzsignal zu empfangen und dasselbe in eine Antennenspannung umzuwandeln;
- eine Verstärkungsschaltung nach einem der Ansprüche 1 bis 9, die dafür konzipiert ist, eine Eingangsspannung ($v_{IN}$) zu empfangen, die aus der Antennenspannung stammt.

**Claims**

1. An amplification circuit, comprising:

- an input (IN) for receiving an input voltage ($v_{IN}$),
- an output (OUT) for exhibiting an output voltage ($v_{OUT}$),
- a primary amplifier (202, 602, 702) designed to:

+ receive the input voltage ($v_{IN}$) from the input (IN),
+ receive a primary control voltage ($v_{CTL,1}$),
+ amplify the input voltage ($v_{IN}$) by a primary gain ($G_1$) by amplifying a difference between the input voltage ($v_{IN}$) and the primary control voltage ($v_{CTL,1}$), the output voltage ($v_{OUT}$) corresponding to the input voltage ($v_{IN}$) amplified this way,
+ supply the output voltage ($v_{OUT}$) to the output (OUT),

- a secondary amplifier (212, 604, 714) designed to:

+ receive the input voltage ($v_{IN}$) from the input (IN),
+ amplify the input voltage ($v_{IN}$) by a secondary gain (G2), the primary control voltage ($v_{CTL,1}$) corresponding to the input voltage ($v_{IN}$) amplified this way,

+ supply the primary control voltage ($v_{CTL,1}$) to the primary amplifier,

wherein the secondary amplifier (212, 604, 714) is designed to have in operation an input admittance ($g_2$) of at least 1 millisiemens, the secondary amplifier (212, 604, 714) is designed to receive a secondary control voltage ($v_{CTL,2}$) and to amplify the input voltage ($v_{IN}$) by the secondary gain ($G_2$) by amplifying a difference between the input voltage ($v_{IN}$) and the secondary control voltage ($v_{CTL,2}$), and wherein the amplification circuit further comprises a tertiary amplifier (226, 724, 802) designed to amplify a tertiary input voltage dependent on the input voltage ($V_{in}$) by a tertiary gain ($G_3$), the secondary control voltage ($v_{CTL,2}$) corresponding to the tertiary input voltage amplified this way.

2. The amplification circuit according to claim 1, wherein the primary amplifier (202, 602, 702) is designed to have in operation an input admittance ($g_1$) of at least 1 millisiemens.

3. The amplification circuit according to claim 1 or 2, wherein the secondary gain ($G_2$) is strictly greater in absolute terms than 1.

4. The amplification circuit according to any of claims 1 to 3, wherein the tertiary gain ($G_3$) is equal in absolute terms to 1.

5. The amplification circuit according to any of claims 1 to 3, wherein the tertiary gain is strictly less in absolute terms than 1.

6. The amplification circuit according to any of claims 1 to 5, wherein the tertiary input voltage is the input voltage ($V_{IN}$).

7. The amplification terms according to any of claims 1 to 5, wherein the tertiary input voltage is the output voltage ($V_{OUT}$).

8. The amplification circuit according to any of claims 1 to 7, wherein the input voltage ($v_{IN}$) and/or the output voltage ($v_{OUT}$) is/are in differential form.

9. The amplification circuit according to any of claims 1 to 8, wherein the primary amplifier (202, 602, 702) comprises a field effect transistor in a common-gate assembly having a source, a gate and a transconductance, and wherein the field effect transistor in common-gate assembly is designed to receive an input voltage potential on its source and a primary control voltage potential on its gate such that the amplification of the difference between the input voltage and the primary control voltage depends on its transconductance.

10. A reception chain, comprising:

   - an antenna designed to receive a radiofrequency signal and convert same into an antenna voltage,
   - an amplification circuit according to any of claims 1 to 9, designed to receive an input voltage ($v_{IN}$) from the antenna voltage.

Figure 1

## Figure 2

Figure 3

Figure 4

Figure 5

Figure 6

Figure 7

Figure 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070057724 A1

**Littérature non-brevet citée dans la description**

- **S.B.T WANG ; A.M. NIKNEJAD ; R.W. BROD-ERSEN.** Design of a Sub-mW 960-MHz UWB CMOS LNA. *IEEE JSSC,* Novembre 2006, vol. 41 (11
- **W. ZHUO ; S. EMBABI ; J.P. DE GYVEZ ; E. SANCHEZ-SINENCIO.** Using Capacitive Cross-Coupling Technique in RF Low Noise Amplifiers and Down-Conversion Mixer Design. *IEEE ESS-CIRC,* Mai 2000, 77-80
- **WOO ; S. KIM.** A 3.6mW Differential Common Gate CMOS LNA with Positive-Negative Feedback. *IEEE ISSCC,* Février 2009, 218-219

- **H. WANG ; L. ZHANG ; Z. YU.** A Wideband Inductorless LNA With Local Feedback and Noise Cancelling for Low-Power Low-Voltage Applications. *IEEE TCAS I,* Août 2010, vol. 57 (8
- **X .LI ; S. SHEKHAR ; D.J. ALLSTOT.** Gm-boosted Common-Gate LNA and Differential Colpitts VCO/QVCO in 0.18-$\mu$m CMOS. *IEEE JSSC,* Décembre 2005, vol. 40 (12
- **I.R. CHAMAS ; S. RAMAN.** Analysis, Design, and X-Band Implementation of a Self-Biased Active Feedback gm-Boosted, Common-Gate CMOS LNA. *IEEE MTT,* Mars 2009, vol. 57 (3